# EUROPÄISCHE PATENTANMELDUNG

(11) **EP 1 262 923 A2**
(43) Veröffentlichungstag der Anmeldung: **04.12.2002**
(21) Anmeldenummer: 02008782.1
(22) Anmeldetag: 19.04.2002
(51) Int. Cl.: G07C 5/08

(54) **Autoradio mit einer integrierten Vorrichtung zur Protokollierung von Fahrtparametern eines Kraftfahrzeugs**

(30) Priorität: 21.04.2001 DE 10119547
(71) Anmelder: GRUNDIG Aktiengesellschaft, 90471 Nürnberg (DE)
(72) Erfinder: Ziegler, Cornelius, 90522 Oberasbach (DE)

(57) **Zusammenfassung**

Die Erfindung betrifft ein Autoradio mit einer integrierten Vorrichtung zur Protokollierung von Fahrtparametern eines Kraftfahrzeugs. Dieser gehört ein ohnehin vorhandener Eingangsanschluss für geschwindigkeitsabhängige Tachoimpulse, eine Recheneinheit, ein Echtzeitgeber und ein Speicher an. Weiterhin werden der beanspruchten Vorrichtung über einen Bus weitere fahrtrelevante Daten zugeführt.

## Beschreibung

Die Erfindung betrifft ein Autoradio.

Autoradios sind üblicherweise zum Empfang und zur Verarbeitung von Hörrundfunksignalen vorgesehen, die dann über im Auto vorgesehene Lautsprecher wiedergegeben werden. Es sind auch bereits Autoradios mit integriertem Kassettenteil, Autoradios mit integriertem CD-Teil und Autoradios mit integriertem Navigationsteil bekannt.

Weiterhin sind bereits Autoradios mit geschwindigkeitsabhängiger Lautstärkeregelung bekannt. Diese Autoradios weisen einen standardisierten ISO-Anschlussstecker auf, welcher mit einem Anschlusspin versehen ist, über welchen dem Autoradio Tachoimpulse zur Verfügung gestellt werden. Diese Tachoimpulse enthalten Informationen über die momentane Geschwindigkeit des Autos und werden vom Mikrocomputer des Autoradios zur Lautstärkeregelung in Abhängigkeit von der momentanen Geschwindigkeit des Autos verwendet.

Ferner sind bereits Fahrtenschreiber und Unfallschreiber bekannt, die zur Abspeicherung von Fahrtparametern dienen, um im nachhinein den Fahrtverlauf oder einen Unfallhergang eines Fahrzeugs rekonstruieren zu können. Dabei handelt es sich jeweils um eigenständige Geräte, die fahrt- oder unfallrelevante Daten wie die Uhrzeit, die Geschwindigkeit, die Beschleunigung bzw. Verzögerung des Fahrzeugs und Daten über die Lenkung des Fahrzeugs, die den genannten Geräten von entsprechenden Sensoren zugeführt werden, über einen bestimmten Zeitraum registrieren und speichern.

Beispiele für einen bekannten Unfalldatenschreiber und ein bekanntes Verfahren zur Analyse eines Unfallgeschehens sind Gegenstand der DE 195 09 711 C2. Dort wird ein in einem Fahrzeug angeordneter elektronischer Unfalldatenspeicher näher beschrieben, welcher zur Speicherung von Daten vorgesehen ist, die ein Unfallgeschehen charakterisieren. Der bekannte Unfalldatenschreiber weist einen als Ringspeicher ausgebildeten Datenspeicher zur Aufzeichnung dieser Daten und mindestens zwei im wesentlichen horizontal und in einem Winkel zueinander ausgerichtete Beschleunigungssensoren auf. Alternativ dazu kann der bekannte Unfallschreiber auch mit einer Datenschnittstelle versehen sein, an die entsprechende außerhalb der Geräteeinheit des Unfallschreibers im Fahrzeug angeordnete Beschleunigungssensoren anschliessbar sind, insbesondere die Beschleunigungssensoren zur Auslösung eines Airbag-Systems. Ferner ist im bekannten Fall eine Datenschnittstelle für ein Positionsbestimmungsgerät auf der Basis eines Satellitennavigationssystems vorgesehen. Weiterhin wird bei dem bekannten Unfallschreiber zur genaueren Datenerfassung für eine spätere Rekonstruktion eines Unfallgeschehens zusätzlich zu den Daten der Beschleunigungssensoren die während des Unfallgeschehens in kurzen zeitlichen Abständen vom GPS-Empfänger ermittelten Daten über die Position, die Geschwindigkeit und die Bewegungsrichtung des Fahrzeugs sowie die zugehörige genaue Uhrzeit auf dem Ringspeicher aufgezeichnet.

Weiterhin ist aus der DE 196 08 232 A1 eine Vorrichtung zum Steuern und/oder Aufzeichnen von Kraftfahrzeugfunktionen und/oder -zuständen bekannt. Diese bekannte Vorrichtung, die ebenfalls in einem Fahrzeug angeordnet ist, weist eine Datenkarten-Erfassungs- und/oder Aufzeichnungseinrichtung zum Erfassen von auf der Datenkarte gespeicherten Daten und/oder zum Steuern und/oder Aufzeichnen von Kraftfahrzeugfunktionen auf. Wird die bekannte Vorrichtung zur Unfalldokumentation verwendet, dann werden Daten wie die Fahrzeuggeschwindigkeit, Bremsvorgänge und Kupplungsvorgänge zum Zeitpunkt einer Kollision sowie Daten betreffend Radblockaden und Daten betreffend die Stelle eines Aufpralls gegen ein Hindernis bzw. ein anderes Fahrzeug aufgezeichnet.

Ausgehend von diesem Stand der Technik liegt der Erfindung die Aufgabe zugrunde, einen Weg aufzuzeigen, wie ein Fahrten- oder ein Unfallschreiber eines Kraftfahrzeugs auf einfachere Weise realisiert werden kann.

Diese Aufgabe wird durch die im Anspruch 1 angegebenen Merkmale gelöst. Vorteilhafte Ausgestaltungen und Weiterbildungen der Erfindung ergeben sich aus den abhängigen Ansprüchen.

Die Vorteile der Erfindung bestehen insbesondere darin, dass aufgrund der Integration einer Vorrichtung zur Protokollierung von Fahrtparametern eines Kraftfahrzeugs in ein Autoradio die Notwendigkeit, ein eigenständiges Gerät als Fahrten- bzw. Unfallschreiber vorzusehen, entfällt. Dadurch entfällt auch der Aufwand für die Installation eines eigenständigen Gerätes. Es muss kein Platz für ein eigenständiges Gerät freigehalten bzw. geschaffen werden. Weiterhin wird die Realisierung eines Fahrten- bzw. Unfallschreibers im Vergleich zum Stand der Technik verbilligt.

In vorteilhafter Weise kann der bei Autoradios mit geschwindigkeitsabhängiger Lautstärkeregelung ohnehin vorhandene Anschluss, über welchen dem Autoradio geschwindigkeitsabhängige Tachoimpulse zugeführt werden, für die Zwecke der beanspruchten Vorrichtung mitverwendet werden. Dies bedeutet eine weitere Einsparung von Installationsaufwand und Kosten.

Gemäß einer vorteilhaften Weiterbildung der Erfindung kann der für eine Protokollierung von Fahrtparametern notwendige Echtzeitgeber durch ein RDSoder DAB-Empfangsteil des Autoradios gebildet sein. In diesem werden zusammen mit einem Hörrundfunksignal übertragene Daten, die die Echtzeit repräsentieren, vom Hörrundfunksignal getrennt und der Vorrichtung zur Protokollierung von Fahrtparametern zugeführt. Diese weist eine Recheneinheit auf, die aus den ihr zugeführten Daten ein zeitliches Geschwindigkeitsprofil des Kraftfahrzeugs ermittelt.

Vorzugsweise erfolgt eine Abspeicherung der dem zeitlichen Geschwindigkeitsprofil entsprechenden Daten in einem nichtflüchtigen Speicher des Autoradios. Handelt es sich bei diesem nichtflüchtigen Speicher um eine in das Autoradio eingesteckte Speicherkarte, dann kann diese nach einem Unfall aus dem Autoradio genommen und die darauf aufgezeichneten Daten können mittels eines externen Lesegerätes ausgewertet werden. In vorteilhafter Weise können die aufgezeichneten Daten auch auf dem Display des Autoradios angezeigt werden.

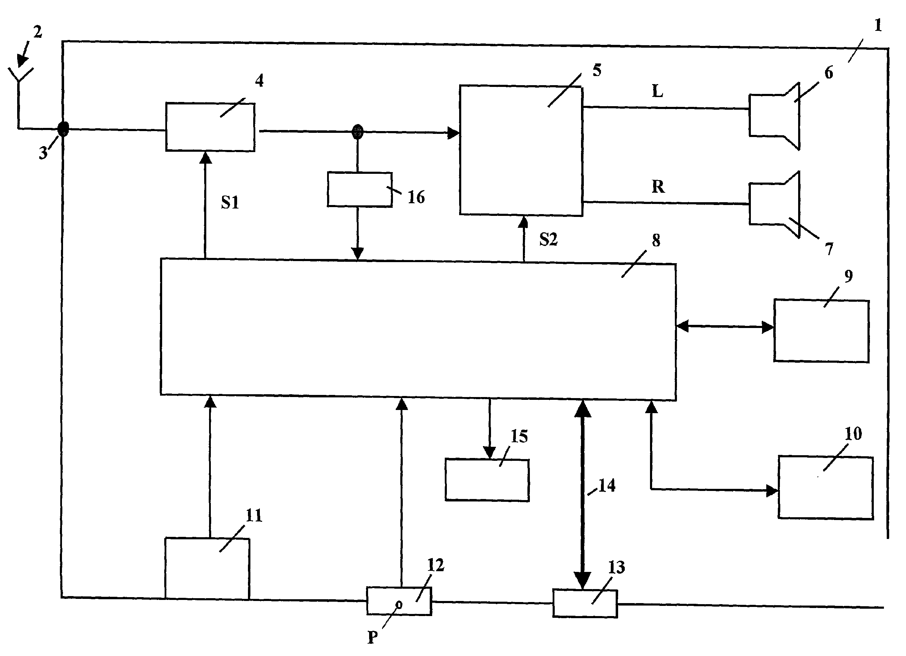

Weitere vorteilhafte Eigenschaften der Erfindung ergeben sich aus der Erläuterung eines Ausführungsbeispiels anhand der Figur. Diese zeigt ein Blockschaltbild eines Autoradios mit einer integrierten Vorrichtung zur Protokollierung von Fahrtparametern eines Kraftfahrzeugs.

Das dargestellte Autoradio 1 ist über seine Antennenbuchse 3 an eine Empfangsantenne 2 angeschlossen. Die empfangenen Rundfunksignale werden von der Antennenbuchse 3 aus einem Empfangsteil 4 zugeführt, welches einen Tuner aufweist. Die Ausgangssignale des Empfangsteils 4 werden in einer Signalverarbeitungsschaltung 5 weiterverarbeitet. Am Ausgang der Signalverarbeitungsschaltung 5 liegen ein Audio-Linkskanal-Signal L und ein Audio-Rechtskanal-Signal R vor, welche Lautsprechern 6 und 7 zugeführt werden.

Die Umschaltung des Empfangsteils 4 und eine Steuerung der Signalverarbeitungsschaltung 5 erfolgen durch einen Mikrocomputer 8. Dieser generiert die Steuersignale S1 für das Empfangsteil 4 und S2 für die Signalverarbeitungsschaltung 5 in Abhängigkeit von Bediensignalen, die dem Mikrocomputer 8 von einer Bedieneinheit 11 zugeführt werden. Die zur Umschaltung auf einen gewünschten Empfangskanal notwendigen Abstimmdaten sind in einem Senderspeicher 9 abgelegt und werden vom Mikrocomputer 8 bei Bedarf von dort ausgelesen.

Das Autoradio 1 weist weiterhin einen standardisierten ISO-Anschlussstecker 12 auf, welcher unter anderem mit einem Anschlusspin P versehen ist, über den dem Autoradio Tachoimpulse zugeführt werden, die die momentane Fahrtgeschwindigkeit des Autos repräsentieren. Diese Tachoimpulse werden vom Mikrocomputer 8 dazu verwendet, eine geschwindigkeitsabhängige Lautstärkeregelung durchzuführen. Die gegebenenfalls notwendige Lautstärkeverändeung erfolgt mittels der Steuersignale S2.

Weiterhin wird das Ausgangssignal des Empfangsteils 4 über einen RDS-Decoder 16 dem Mikrocomputer 8 zugeführt. Im decodierten RDS-Signal sind sender- oder programmspezifische alphanumerische Zusatzdaten enthalten, die auf dem Display 15 des Autoradios 1 dargestellt werden.

Gemäß der vorliegenden Erfindung wird das Autoradio zusätzlich als Fahrten- bzw. Unfalldatenschreiber benutzt. Zu diesem Zweck weist das gezeigte Autoradio zusätzlich zu den bereits genannten Bauteilen weiterhin einen Busanschluss 13, einen Bus 14 und einen Datenspeicher 10 auf. Weiterhin werden das Empfangsteil 4, der Mikrocomputer 8, der Anschlussstecker 12 und das Display 15 nicht nur im Autoradiobetrieb, sondern auch zur Realisierung des Fahrten- bzw. Unfalldatenschreiberbetriebes verwendet.

Im Rahmen der letztgenannten Funktion werden die ohnehin vorhandenen, dem Autoradio über den Anschlusspin P zugeführten Tachoimpulse im Mikrocomputer 8 auch zur Erstellung eines zeitlichen Geschwindigkeitsprofils des Autos verwendet. Vorzugsweise sind die Zeitabstände zwischen den Tachoimpulsen so kurz gewählt, dass sie im Millisekundenbereich liegen. Dadurch kann sichergestellt werden, dass die Protokollierung der Fahrtparameter in genügend kurzen Zeitabständen erfolgen kann, die eine gute Reproduktion der unmittelbar vor einem Unfall vorliegenden Fahrtparameter erlauben.

Weiterhin ist das Autoradio mit einem Echtzeitgeber versehen oder verbunden, welcher dem Mikrocomputer 8 Echtzeitinformationen liefert. Beim gezeigten Ausführungsbeispiel wird die Echtzeitinformation aus dem am Ausgang des Empfangsteils 4 vorliegenden und im RDS-Decoder 16 decodierten RDS-Signal abgeleitet. Alternativ dazu kann die benötigte Echtzeitinformation von einer im Autoradio vorhandenen oder mit dem Autoradio verbundenen Echtzeituhr oder von einem DAB-Empfangsteil des Autoradios abgeleitet werden. Ferner kann die Echtzeitinformation auch von einem im Auto vorhandenen DCF-Empfänger oder von einer Navigationsvorrichtung zur Verfügung gestellt werden.

Der Mikrocomputer 8 ist derart programmiert, dass er aus den geschwindigkeitsabhängigen Tachoimpulsen und der Echtzeitinformation bei bewegtem Auto automatisch und permanent das zeitliche Geschwindigkeitsprofil des Autos berechnet. Vorzugsweise gehen in die Berechnung des zeitlichen Geschwindigkeitsprofils des Autos weitere Daten ein, die den Mikrocomputer 8 über den Busanschluss 13 und den Bus 14 zugeführt werden. Bei diesem Bus handelt es sich beispielsweise um einen im Auto vorgesehen CAN-Bus oder einen MOST-Bus, über welchen bei einer entsprechenden Vernetzung im Auto eine Vielzahl weiterer fahrtrelevanter Daten übertragen wird. Dazu gehören sämtliche Steuer- und Diagnosedaten für den Motor, die Bremsen, die Lenkung, den Airbag usw.. Im weiteren kommen auch komprimierte Videodaten (bzw. -bilder und/oder -sequenzen) die von einer am oder im Fahrzeug angeordneten Videokamera stammen hinzu.

Die vom Mikrocomputer 8 ermittelten Daten, die dem zeitlichen Geschwindigkeitsprofil des Autos entsprechen, werden zusammen mit der aktuellen Uhrzeit im nichtflüchtigen Speicher 10 abgespeichert. Bei diesem Speicher handelt es sich vorzugsweise um ein NVRAM ( non volatile RAM) einen Flashspeicher oder um eine in das Autoradio 1 eingesteckte Flash-Speicherkarte des Typs, wie sie beispielsweise für eine Musikwiedergabe bei Autoradios Verwendung findet. Um eine nachträgliche Manipulation der abgespeicherten Daten zu verhindern, müssen geeignete Sicherheitsvorkehrungen getroffen werden. Diese können beispielsweise darin bestehen, dass sich bei eventuellen Editierversuchen automatisch auch die mitgespeicherte Uhrzeit verändert. Es besteht auch die Möglichkeit diese Daten schreibgeschützt aufzuzeichnen, d.h. dass die Daten nicht verändert werden können, oder dass sie verschlüsselt abgelegt werden, wodurch ebenfalls eine Manipulation erschwert wird.

Eine Ausgabe der gespeicherten Daten kann in vorteilhafter Weise auf dem ohnehin vorhandenen Display 15 des Autoradios 1 erfolgen. Handelt es sich bei dem nichtflüchtigen Speicher 10 um eine entnehmbare Speicherkarte, dann kann diese zu einer Wiedergabe der gespeicherten Daten auch aus dem Autoradio entnommen, in ein externes Lesegerät, beispielsweise einen Personalcomputer, eingeschoben und auf einem diesem zugeordneten Display angezeigt werden. Das externe Lesegerät kann auch mit einem Personalcomputer verbunden werden oder in diesem integriert sein.
Es besteht auch die Möglichkeit die Daten über eine Schnittstelle am Autoradio mit einem entsprechenden Gerät auszulesen. Diese Ausführungsform ist insbesondere dann anzuwenden, wenn im Gerät ein nichtflüchtiger Speicher, welcher nicht entnehmbar ist, eingesetzt wird.

Da es zur Rekonstruktion eines Unfallgeschehens im allgemeinen ausreicht, die Fahrtparameter der letzten 10 Sekunden vor dem Unfall aufzuzeichnen, ist der Speicher 10 als Ringspeicher ausgebildet, dessen Speicherkapazität derart dimensioniert ist, dass das zeitliche Geschwindigkeitsprofil über eine Zeitdauer von 10 Sekunden abgespeichert werden kann. Durch die Ausbildung als Ringspeicher ist dabei sichergestellt, dass stets die ältesten abgespeicherten Daten durch aktuelle Daten überschrieben werden.

Wird anhand der Ausgangssignale eines Chrashsensors, welche dem Mikrocomputer 8 zugeführt werden, das Auftreten eines Unfalls erkannt, dann wird das Einschreiben von Daten in den Speicher 10 gestoppt. Dadurch wird erreicht, dass die zur Rekonstruktion des Unfallgeschehens notwendigen Daten erhalten bleiben und nicht durch neue Daten überschrieben werden.

Eine weitere vorteilhafte Ausgestalung der Erfindung sieht vor, dass das Einschreiben von Daten in den Speicher gestoppt wird wenn und solange die Geschwindigkeit des Fahrzeuges null ist. Hierbei wird in vorteilhafter Weise über die SCV-lmpulse die Zeit abgetastet.

In einer alternativen Ausführungsform wird das Einschreiben von Daten in den Speicher gestoppt, wenn eine entsprechende Taste durch den Nutzer betätigt wird. Es wird somit ein manueller Aufzeichnungsstopp ermöglicht.

## Patentansprüche

1. Autoradio mit einer integrierten Vorrichtung (4, 16, 8, 10, 12, 13, 14) zur Protokollierung von Fahrtparametern eines Kraftfahrzeugs
**dadurch gekennzeichnet, dass**
die integrierte Vorrichtung zur Protokollierung von Fahrtparametern einen Eingangsanschluss aufweist, welcher zum Empfang von Tachoimpulsen dient, die die momentane Fahrtgeschwindigkeit des Autos repräsentieren.

2. Autoradio nach Anspruch 1,
**dadurch gekennzeichnet, dass**
der Eingangsanschluss ein Pin (P) eines Anschlusssteckers (12) und der Anschlussstecker (12) ein Iso-Anschlussstecker ist und die Tachoimpulse dem Eingangsanschluss in Zeitabständen zugeführt werden, die im Millisekundenbereich liegen.

3. Autoradio nach einem der Ansprüche 1 oder 2,
**dadurch gekennzeichnet, dass**
die integrierte Vorrichtung zur Protokollierung von Fahrtparametern einen Echtzeitgeber (4, 16) aufweist oder die integrierte Vorrichtung zur Protokollierung von Fahrtparametern eine Schnittstelle zum Anschluss eines Echtzeitgeber aufweist.

4. Autoradio nach Anspruch 3,
**dadurch gekennzeichnet, dass**
der Echtzeitgeber eine Echtzeituhr oder ein DCF-Empfänger oder eine Navigationsvorrichtung oder ein RDS- Empfangsteil oder ein DAB-Empfangsteil ist.

5. Autoradio nach einem der Ansprüche 1 bis 4,
**dadurch gekennzeichnet, dass**
die integrierte Vorrichtung zur Protokollierung von Fahrtparametern eine Recheneinheit (8) aufweist, die Recheneinheit ein Mikrocomputer und der Mikrocomputer derart programmiert ist, dass er bei bewegtem Kraftfahrzeug automatisch und permanent für einen definierten Zeitraum unter Verwendung der Tachoimpulse und einer Zeitinformation des Echtzeitgebers ein zeitliches Geschwindigkeitsprofil des Kraftfahrzeugs berechnet.

6. Autoradio nach Anspruch 5,
**dadurch gekennzeichnet, dass**
das zeitliche Geschwindigkeitsprofil Informationen über die zu bestimmten Zeitpunkten vorliegenden Geschwindigkeiten des Kraftfahrzeugs enthält.

7. Autoradio nach einem der Ansprüche 5 oder 6,
**dadurch gekennzeichnet, dass**
die Recheneinheit die zentrale Steuereinheit des Autoradios ist, die Recheneinheit einen nichtflüchtigen Speicher (10) aufweist, der zur Abspeicherung von Informationen über das zeitliche Geschwindigkeitsprofil vorgesehen ist, der nichtflüchtige Speicher (10) ein NVRAM oder eine Flash-Spicher des Autoradios oder eine in das Autoradio eingesteckte Speicherkarte ist und der nichtflüchtige Speicher (10) vor nachträglichen Manipulationen geschützt ist.

8. Autoradio nach Anspruch 7,
**dadurch gekennzeichnet, dass**
bei einem Beschreiben des Speichers (10) stets die aktuelle Uhrzeit mit aufgezeichnet wird.

9. Autoradio nach einem der Ansprüche 1 bis 8,
**dadurch gekennzeichnet, dass**
es ein Display (15) aufweist, welches zur Darstellung der im nichtflüchtigen Speicher (10) abgespeicherten Informationen dient.

10. Autoradio nach einem der Ansprüche 1 bis 9,
**dadurch gekennzeichnet, dass**
die im nichtflüchtigen Speicher (10) abgespeicherten Informationen über einen Autoradio-Bus (14) ausgebbar sind und/oder der nichtflüchtige Speicher (10) aktualisierbar ist, wobei die ältesten Speicherdaten durch neue Speicherdaten ersetzt werden und eine Aktualisierung nur bei bewegtem Fahrzeug erfolgt.

11. Autoradio nach Anspruch 10,
**dadurch gekennzeichnet, dass**
die Vorrichtung zur Protokollierung von Fahrtparametern einen Eingang für von einem Crashsensor abgeleitete Signalen aufweist und eine Aktualisierung des nichtflüchtigen Speichers (10) nach einem Erkennen eines Fahrzeugunfalls unterbleibt.

12. Autoradio nach Anspruch 10,
**dadurch gekennzeichnet, dass**
die Vorrichtung zur Protokollierung von Fahrtparametern eine Aktualisierung des nichtflüchtigen Speichers (10) stoppt wenn und/oder sobald die Geschwindigkeit des Fahrzeuges null ist und/oder über eine Taste am Autoradio die Aufzeichnung manuell gestoppt wird.

13. Autoradio nach einem der Ansprüche 10 bis 12,
**dadurch gekennzeichnet, dass**
der Autoradio-Bus (14) ein CAN-Bus oder ein MOST-Bus ist und der Vorrichtung zur Protokollierung von Fahrtparametern über diesen Bus weitere fahrtrelevante Daten zuführbar sind und/oder die weiteren fahrtrelevante Daten Steuer- und Diagnosedaten für den Motor, die Bremsen und/oder die Lenkung enthalten.
